# EUROPEAN PATENT SPECIFICATION

(11) **EP 0 294 236 B1**
(45) Date of publication and mention of the grant of the patent: **27.01.1993**
(21) Application number: 88305118.7
(22) Date of filing: 03.06.1988
(51) Int. Cl.: G03B 27/00

(54) **Image printers**
Ausdrucken von Bildinformationen
Imprimeur d'image

(30) Priority: 05.06.1987 JP 140912/87
(43) Date of publication of application: 07.12.1988
(73) Proprietor: SONY CORPORATION, Tokyo 141 (JP)
(72) Inventor: Yui, Yasuji Patent Division, Shinagawa-ku Tokyo 141 (JP); Hitachi, Akio Patent Division, Shinagawa-ku Tokyo 141 (JP); Sato, Tatsura Patent Division, Shinagawa-ku Tokyo 141 (JP); Shirakura, Akira Patent Division, Shinagawa-ku Tokyo 141 (JP)
(74) Representative: Thomas, Christopher Hugo

(56) References cited:
- DE-A- 2 262 845
- FR-A- 2 171 341
- US-A- 3 458 256
- US-A- 3 734 617
- US-A- 4 149 887

## Description

This invention relates to image printers.

Various printing systems are known, such as thermal types, pen types, dot types and ink-jet types, for printing a predetermined image on printing paper. The image may, for example, be a television image received on a television receiver or a recorded image recorded on a recording medium such as a magnetic tape or optical disc. In one such system, the surface of a photosensitive film provided with photosensitive microcapsules is exposed to light corresponding to an image signal to form a photographic film, and the exposed film is overlapped with a piece of printing paper and pressed thereagainst so that the picture can be printed on the printing paper.

For example, Japanese laid-open patent application number 59/30537 discloses a printing system using a photosensitive film which has thereon very small photosensitive microcapsules, which become hardened on exposure to light, and which contain a colouring precursor substance which reacts with a developing material on a piece of printing paper to form colours. The sensitive surface of the photosensitive film carrying the microcapsules is exposed to, for example, ultraviolet light in accordance with the picture elements of a picture, so that a positive photographic film can be produced. The exposed side of the photosensitive film is overlapped with the printing paper, and pressed thereagainst so that the microcapsules which were not exposed to light are broken and release the colouring precursor substance therein, which is transferred to the printing paper. Thus, the picture is printed on the printing paper.

When printing pictures in this way, the efficiency can be improved by using continuous paper type photosensitive film, that is a long roll of photosensitive film wound on a spool and sufficient to form a large number of photographic frames.

A printer has therefore been proposed defining a path in which the photosensitive film can travel, exposing means disposed adjacent to this path, a roller member disposed ahead of the exposing means to pinch and feed the photosensitive film so that the photosensitive film can be exposed by the exposing means, and printing paper supplying means which supplies a printing paper and causes it to be overlapped with the exposed portion of the photosensitive film, the overlapped printing paper and film being transported together and pressed by the roller member so as to achieve the printing.

In this construction, however, when printing of a picture on the printing paper is completed, the trailing end of the photographic frame on the photosensitive film will always be between the roller member and the exposing means or at a position a little ahead thereof, and thus when the next frame is started to be formed, waste of photosensitive film occurs between the roller member and the exposing means.

Such waste can amount to half the length of the photosensitive film.

According to the present invention there is provided a printer for printing an image on a sheet of printing paper by exposing a sensitive surface of an elongated photosensitive film carrying photosensitive microcapsules to light corresponding to said image to form a photographic film frame, overlapping the exposed surface of the film on the printing paper, and applying pressure to the overlapping portion, the printer comprising:
a supply spool on which the film is wound;
a take-up spool on which the film withdrawn from said supply spool is wound;
exposing means for exposing the portion of the film facing said exposing means to light;
printing paper supplying means for supplying the printing paper; and feeding means for feeding the film in the winding direction from the supply spool towards the take-up spool, so that the exposed portion is moved from the position facing the exposing means towards a position where press rollers are located;
said press rollers causing the film to overlap with the supplied printing paper and pressing the overlapping portion while the film and the printing paper are being passed together between said rollers in the winding direction;
characterized by:
film rewinding means for permitting said supply spool to rotate in the film rewinding direction opposite to said winding direction; and roller drive means for driving the press rollers to rotate;
said film rewinding means being constructed such that, after the printing of the printing paper, said film rewinding means is driven to rewind the film until the part of the non-exposed portion of the film adjacent to the exposed portion of the film is returned to the position facing said exposing means.

The invention will now be described by way of example with reference to the accompanying drawings, throughout which like parts are referred to by like references, and in which:
Figure 1 is a longitudinal cross-sectional view of an embodiment of printer according to the present invention;
Figure 2 is a plan view thereof with a part of its outer case cut away;
Figure 3 is a perspective view of main a portion thereof;
Figure 4 is a cross-sectional and developed view of the printing paper discharging system taken through the line IV-IV in Figure 1;
Figure 5 is a conceptual diagram for explaining the movement of the driving portion of the printing and paper discharging system;
Figure 6 is a cross-sectional and developed view of the driving portion for the paper supply and film rewinding system, taken through the line VI-VI in Figure 1; and
Figure 7 is a conceptual diagram for explaining the movement of the driving portion for the paper supply and film rewinding system.

The embodiment shown in the drawings is the application of this invention to a printer 1 for printing images in so-called all colour on a printing paper through a photosensitive film which has on its photosensitive surface a mixture of a plurality of kinds of colouring precursor carriers including photosensitive microcapsules of three primary colours.

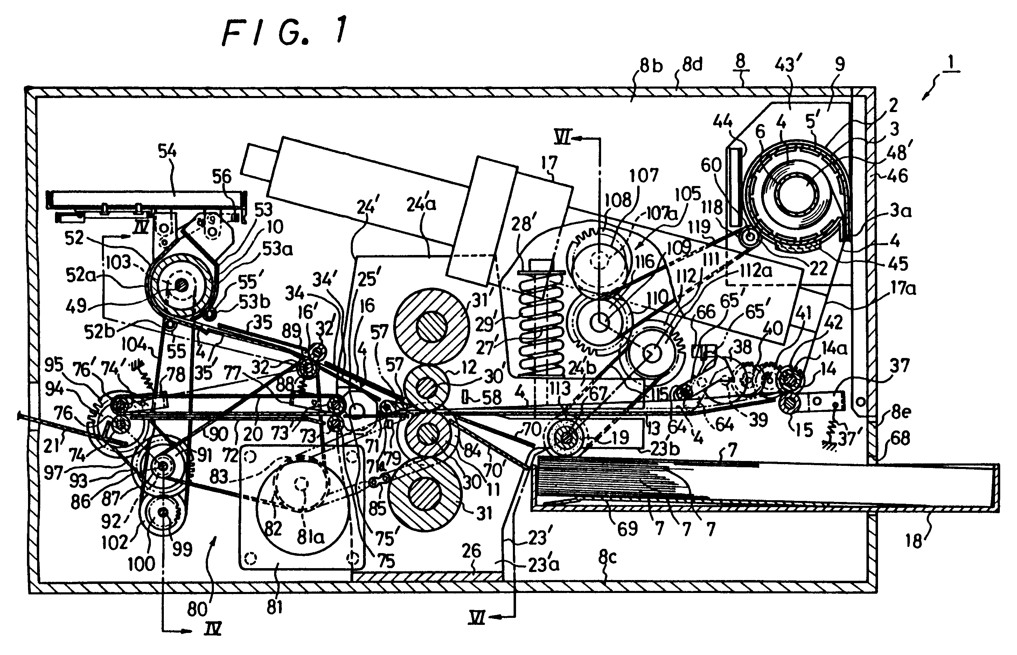

Before describing the printer 1, examples of a film cassette in which the photosensitive film to be used in the printer 1 is accommodated, and the printing paper will be described with reference to Figures 1 to 3.

The film cassette 2 comprises a cassette case 3 of a substantially cylindrical shape and a supply spool 6 on which a long length of photosensitive film is wound in a roll, and which has light shielding flanges 5 and 5′ of slightly larger diameter than the outer diameter of the case 3, provided at the axial ends of the case 3. The supply spool 6 is supported by the case 3 to be rotatable relative to the case 3 with its flanges 5 and 5′ closing the end openings of the case 3. The leading end of the film 4 wound on the supply spool 6 is led out, passing through a film outlet 3a formed on the outer periphery of the case 3.

The film 4 comprises a film base with photosensitive microcapsules on one surface. These microcapsules are very small capsules which are changed in their molecular coupling structure and hardened by exposure to, for example, ultraviolet light of a certain wavelength, and in which is enclosed a predetermined colouring precursor substance, that is, a substance that reacts with a developing substance on a printing paper to be described later, to make certain colours. Each capsule contains a colouring precursor substance of one or three different colours, for example, to result in red, blue and green colouring matter on the printing paper. These microcapsules are mixed and deposited on one surface of the film base.

In addition, the hardening characteristics of these capsules differ for the different colouring precursor substances, so as only to be hardened when irradiated with light rays of predetermined wavelengths.

The leading and trailing end portions of the film 4 are formed as leaders with no microcapsules thereon, and the remainder of one surface of the film 4 forms the sensitive surface.

Pieces of printing paper 7 are independently formed in a substantially rectangular shape slightly wider than the film 4, and they each have on one surface a predetermined developing substance, that is a substance that reacts with the colouring precursor substance in the microcapsules, to make predetermined colours.

When the printing paper 7 is overlapped with and pressed against the film 4, the non-hardened microcapsules are broken and release the colouring precursor substance, which is transferred to the printing surface of the printing paper 7 and reacts with the developing substance so as to make the predetermined colours.

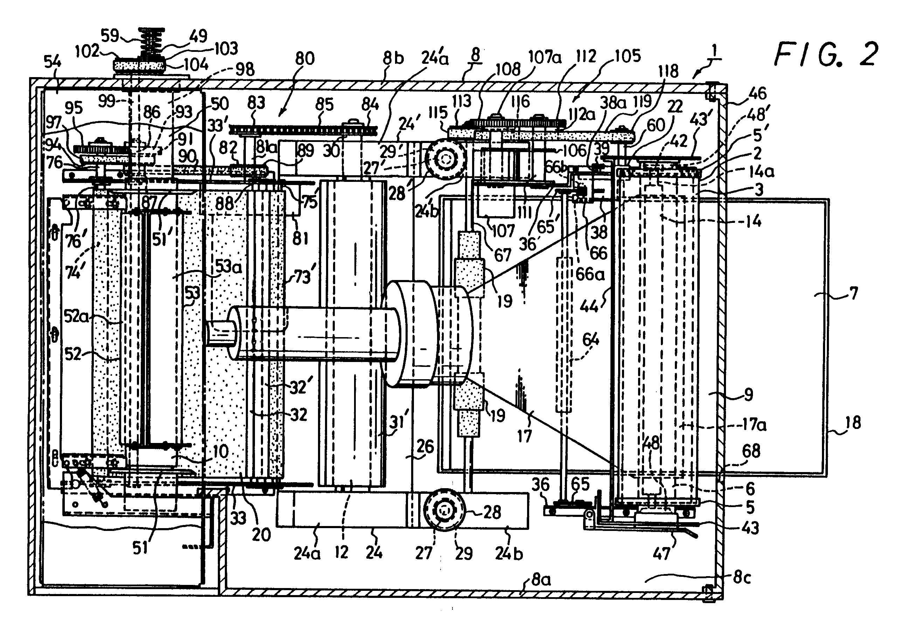

Referring to Figures 1 and 2, an outer case 8 of the printer 1 is a box which is elongated in the left and right directions. (In Figure 2, the left direction indicates the left-hand side of the figure, and the right direction indicates the right-hand side thereof; moreover, the downward direction indicates the front side of the figure, and the upward direction indicates the rear side thereof; and hereinafter these directional terms will be used.)

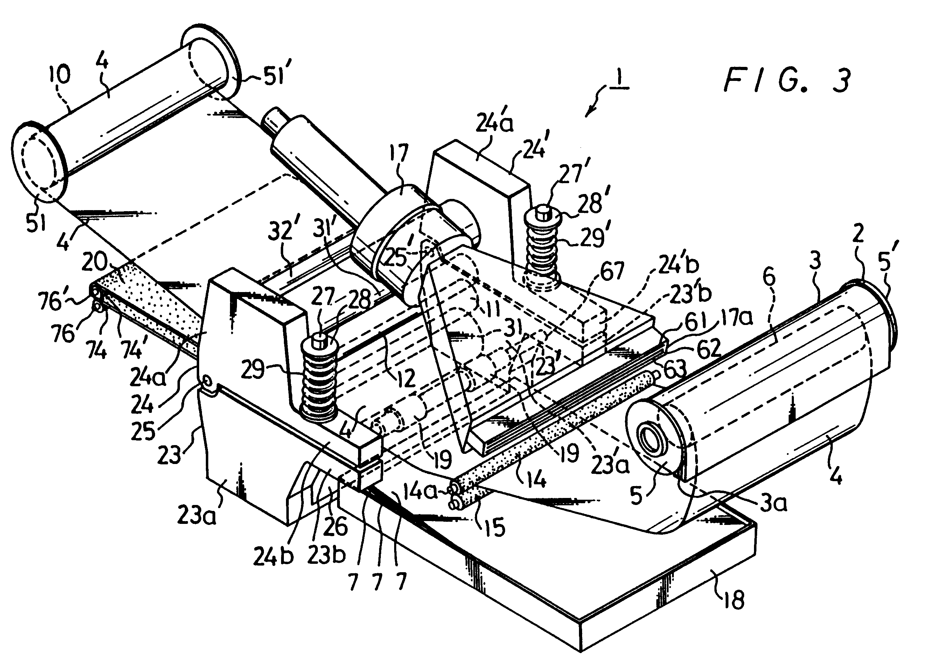

The cassette 2 is detachably mounted in a cassette receiving portion 9, and a take-up spool 10 is provided, on which the film 4 withdrawn from the cassette 2 is wound (the take-up spool 10 is shown somewhat shifted on the left of Figure 3).

A pair of press rollers 11 and 12 are provided within the outer case 8 substantially at the centre in the left-to-right direction. A film guide plate 13 has its right-hand end positioned under the cassette receiving portion 9 and its left-hand end positioned near the entry side of the contact between the press rollers 11 and 12. A pair of film feeding rollers 14 and 15 are positioned near the right-hand side of the film guide plate 13. Film travel paths 16 and 16′ are provided between the exit side of the press rollers 11 and 12 and the take-up spool 10. The film 4 withdrawn from the cassette 2 in the cassette receiving portion 9 is transported between the film feeding rollers 14 and 15, along the upper surface of the film guide plate 13, between the press rollers 11 and 12, along the film paths 16 and 16′, and it is then wound on the take-up spool 10.

A light source 17 is formed by a bundle of a large number of optical fibres through which light is transmitted to expose the sensitive surface of the film 4 in a pattern corresponding to a predetermined picture signal. The light source 17 is hereinafter referred to as a fibre optical tube (FOT). The intermediate portion of the film 4 between the cassette receiving portion 9 and the film feeding rollers 14 and 15 is brought into contact with a light emitting surface 17a of the FOT 17. (In Figure 3, the cassette 2 is shown somewhat shifted to the right.) The film 4 is fed by a constant amount by the film feeding rollers 14 and 15 at each time, and its sensitive surface is exposed by the FOT 17, so that a predetermined region of the film 4 is exposed to form a single picture frame.

A paper supply tray 18 is provided to hold many sheets of the printing paper 7. Each printing paper 7 is fed by a paper supply roller 19 at a predetermined time, so that its leading end is located at the entry side of the contact between the press rollers 11 and 12. Then, the exposed frame of the film 4 is overlapped with this printing paper 7 and pinched between the press rollers 11 and 12 so that the picture on the exposed frame is printed on the printing paper 7.

After printing has been completed, the printing paper 7 is transported by a paper discharge belt 20 to a paper discharge tray 21, and at substantially the same time the supply spool 6 is rotated by a rewind roller 22 to wind the film 4 until the leading end of the non-exposed portion of the film 4 comes into contact with the light-emitting surface 17a of the FOT 17.

Referring to Figures 1 to 3 and 6, there are provided roller supports 23 and 23′, and 24 and 24′ which respectively support the press rollers 11 and 12. The front roller supports 23 and 24 and the rear roller supports 23′ and 24′ are substantially symmetrical with each other, and are respectively located near a front wall 8a and a rear wall 8b of the case 8 substantially at the centre within the case 8 in the left-to-right direction.

Main portions 23a and 23′a, and 24a and 24′a of the roller supports 23 and 23′, and 24 and 24′ are relatively thick plates of a trapezoidal shape and are substantially symmetrical in the upward and downward direction as viewed from the front and rear side. Moreover, the upper ends of the main portions 23a and 23′a of the downward side roller supports 23 and 23′, and the lower ends of the main portions 24a and 24′a of the upward side roller supports 24 and 24′ project to the right and substantially horizontally from their right-hand side edges to form arms 23b and 23′b, and 24b and 24′b. The upper left corners of the main portions 23a and 23′a, of the downward side roller supports 23 and 23′, and the lower left corners of the main portions 24a and 24′a of the upward side roller supports 24 and 24′ are rotatably coupled by pivot pins 25 and 25′. The lower ends of the main portions 23a and 23′a of the downward roller supports 23 and 23′ are connected to a base 26 fixed to a bottom plate 8c of the case 8.

Spring receiving shafts 27 and 27′ project upward from the arms 23b and 23′b of the downward side roller supports 23 and 23′ and penetrate through apertures (not shown) in the arms 24b and 24′b of the upward side roller supports 24 and 24′ so that most parts of them project above the arms 24b and 24′b. On the tops of the spring receiving shafts 27 and 27′ are fixed spring receiving heads 28 and 28′, and compressed coil springs 29 and 29′ are fitted around the spring receiving shafts 27 and 27′, and project between the spring receiving heads 28 and 28′ and the arms 24b and 24′b of the upward side roller supports 24 and 24′. Therefore, the upward side roller supports 24 and 24′ are always urged to rotate in the clockwise direction in Figure 1.

Referring to Figures 1 to 3, the press rollers 11 and 12 are slightly wider than the film 4, and are made of metal or a material with substantially the same hardness as metal. The front and rear ends of a shaft 30 of the downward side press roller 11 are rotatably supported by the main portions 23a and 23′a of the downward side roller supports 23 and 23′ substantially at the centre positions of their upper portions relative to the left-to-right direction. The front and rear ends of a shaft 30′ of the upward side press roller 12 are rotatably supported by the main portions 24a and 24′a of the upward side roller supports 24 and 24′ at the centre positions of their lower portions opposite to the positions where the ends of the shaft 30 are supported.

Since the upward side roller supports 24 and 24′ are urged to rotate in the clockwise direction, the upward side press roller 12 supported by the roller supports 24 and 24′ is also urged to rotate in the clockwise direction in Figure 1. Therefore, the upward and downward side rollers 11 and 12 are pressed against each other by the resilient force of the compressed coil springs 29 and 29′.

Back-up rollers 31 and 31′ are rotatably supported by the downward side roller supports 23 and 23′ and the upward side roller supports 24 and 24′. These back up rollers 31 and 31′ are somewhat larger in diameter than the press rollers 11 and 12. The downward side back-up roller 31 contacts the downward side press roller 11, pressing it upward, while the upward side back-up roller 31′ contacts the upward side press roller 12, pressing it downward. Thus, the press rollers 11 and 12 are pressed against each other with a substantially uniform pressing force over their entire axial length.

The downward press roller 11 is the driving-side press roller, and is rotated in the counter-clockwise direction in Figure 1 when the film 4 is exposed to light (hereinafter, this is referred to as the "exposing mode") and when the image is printed on the printing paper 7 (hereinafter, this is referred to as the "printing mode"). Also when the film 4 is rewound (hereinafter, this is referred as the "film rewinding mode"), the press roller 11 is rotated in the clockwise direction.

As shown in Figure 1, the film guide plate 13 is supported by the downward roller supports 23 and 23′ such that substantially 1/3 of the entire length of the film guide plate 13 measured from the extreme right gradually slopes upward towards the right end, with the remainder of the film guide plate 13 extending substantially horizontal.

Travel assisting rollers 32 and 32′ are provided at about the mid position between the exit side of the contact portion of the press rollers 11 and 12, and the take-up spool 10. The travel assisting rollers 32 and 32′ extend between support chassis 33 and 33′ which are respectively located at the left side of the front side roller supports 23 and 24 and at the left side of the rear side roller supports 23′ and 24′, and the travel assisting rollers 32 and 32′ are rotatably supported by the support chassis 33 and 33′.

The upward side travel assisting roller 32′ is also supported by a roller support arm (not shown) which is rotatably supported by the support chassis 33 and 33′, and pressed against the downward travel assisting roller 32 at all times.

The downward side travel assisting roller 32 is the driving side travel assisting roller, and is rotated in the counter-clockwise direction in Figure 1 in the exposing mode and in the printing mode, and is rotated in the clockwise direction in the film rewinding mode.

Guide plates 34 and 34′, and 35 and 35′ are supported by the support chassis 33 and 33′, and are located between the exit side of the contact portion of the press rollers 11 and 12 and the entry side of the contact portion of the travel assisting rollers 32 and 32′, and between the exit side of the contact portion of the travel assisting rollers 32 and 32′ and the take-up spool 10. The guide plates 34 and 34′ form a flat space therebetween which serves as the film travelling path 16, and the guide plates 35 and 35′ form a flat space therebetween which serves as the film path 16′.

The film feed rollers 14 and 15 move the film 4 by a constant amount at each time in the exposing mode. The upward side film feed roller 14 is rotatably supported between the support chassis 36 and 36′ which are respectively located on the right side of the front side roller supports 23 and 24, and are located substantially on the right side of the rear side roller supports 23′ and 24′ within the outer case 8. The downward side film feed roller 15 is rotatably supported between the support chassis 36 and 36′, and is also rotatably supported by the pivotal end of roller support arms 37, 37 (only the rear side arm is illustrated) that are urged by springs 37′, 37′ in the clockwise direction in Figure 1 thereby to be pressed against the upward side film feed roller 14.

A stepping motor 38 is fixed to the left end of the rear side support chassis 36'. A gear 39 connected to the rotating shaft 38a of the stepping motor 38 is meshed with a gear 42 fixed to the rear end of the shaft 14a of the upward side film feed roller 14 through reduction gears 40 and 41 (shown only in Figure 1). Thus, when the stepping motor 38 rotates, the film feed roller 14 is rotated by a very small pitch in the clockwise direction in Figure 1.

The cassette receiving section 9 is formed by partitioning plates 43 and 43′ provided separately at the upper right front and rear corners within the outer case 8, a rear plate 44 connected between the left ends of the plates 43 and 43′, a bottom plate 45 connected between the lower ends of the plates 43 and 43′, and a door 46 forming part of the right side wall 8e. Moreover, a detaching operation plate 47 is rotatably supported by the front side plate 43, and spool support projections 48 and 47′ (see Figure 2) are provided to face the plate 47 and the rear side plate 43′.

The cassette 2 is loaded in the cassette receiving section 9 such that the film exit 3a is oriented downward, so that the case 3 is held by the plates 44 and 45, and that opposite ends of the supply spool 6 are rotatably supported by the spool support projections 48 and 48′.

As Figures 1 to 3 show, there is provided a spool shaft 49 rotatably supported by a bearing housing 50 of which the back end portion is fixed to the rear wall 8b of the outer case 8 at around its left end position, and the take-up spool 10 is fixed to the projecting portion of the spool shaft 49 forward from the bearing housing 50. Flanges 51 and 51′ are provided at the opposite ends of the take-up spool 10.

Spool covers 52 and 53 are provided to cover the take-up spool 10, and have their main portions 52a and 53a formed substantially in a trough of about the same length as that of the take-up spool 10, and their front and rear side ends supported by an upper chassis 54 which is provided near the top plate 8d of the outer case 8. Also, the main portions 52a and 53a respectively surround substantially the left and right halves of the outer periphery of the take-up spool 10 with a slight spacing therebetween.

Moreover, the main portions 52a and 53a have roller support projections 52b and 53b formed substantially in a cut and raised shape at several positions on their edge portions or near those portions (in the drawings only one projection is shown on each main portion). The roller support projections 52b and 53b rotatably support film pressing rollers 55, 55′.

The spool covers 52 and 53 are urged to rotate by a resilient member 56 (see Figure 1) so that their main portions 52a and 53a are in contact with the outer periphery of the take-up spool 10. Thus, the film pressing rollers 55 and 55′ are brought into resilient contact with the outer periphery of the take-up spool 10.

The end edge of the main portion 52a of the left spool cover 52 extends such that the edge comes into contact with the under side of the left end of the downward side guide plate 35′. Therefore, the film path 16′ communicates with the space between the take-up spool 10 and the spool covers 52 and 53.

Referring to Figure 1, a separate flap 57 is formed in a slender plate shape, long in the front to rear direction, which is substantially of a wedge-like shape with its right end sharp as viewed from this side. The separate flap 57 is located near the exit side of the press rollers 11 and 12, and is pivotally moved between a separate position in which its right end edge contacts the outer periphery of the upward side roller 12 at a point slightly upward from its lowest point as indicated by the solid line in Figure 1, and a guide position in which its right end edge contacts the outer periphery of the downward side press roller 11 at a point slightly downward from its highest point as indicated by the two-dot chain line in Figure 1.

The separate flap 57 is retained in the guide position only when the film 4 is loaded, and it is kept in the separate position at other times.

The film 4 is loaded as follows.

First, the cassette 2 is loaded in the cassette receiving section 9, the film 4 is withdrawn from the case 3 by an appropriate amount, and the leader is inserted between the film feeding rollers 14 and 15. When the film 4 is to be loaded, the separate flap 57 is moved to the guide position, the film feed roller 14 is rotated in the clockwise direction, and the press roller 11 is rotated in the counter-clockwise direction. The travel assisting roller 32 is rotated in the counter-clockwise direction and the take-up spool 10 is rotated in the clockwise direction in Figure 1.

When the film 4 is loaded, the stepping motor 38 is rotated at substantially the same speed as the press rollers 11 and 12.

Thus, the film 4 is moved first by the film feed rollers 14 and 15, and the part thereof appearing on the left side of the film feed rollers 14 and 15 is further moved along the upper surface of the film guide plate 13 and between the press rollers 11 and 12. When the end of the film 4 enters between the press rollers 11 and 12, the film 4 is moved by the press rollers 11 and 12. The portion of the film 4 appearing on the left side of the press rollers 11 and 12 is guided by the separate flap 57 into the space between the guide plates 34 and 34′, and passed through the film paths 16 and 16′. The travel assisting rollers 32 and 32′ prevent the film 4 from becoming slack in the film paths 16 and 16′. Then, the film 4 is slipped into the space between the take-up spool 10 and the spool covers 52 and 53, and wound on the take-up spool 10 by the film pressing rollers 55 and 55′.

A film sensor 58 is provided above the film guide plate 13 and close to the press rollers 11 and 12.

The film 4 has elements to be detected by the film sensor 58 provided along one edge at a constant pitch slightly longer than the length of the printing paper 7. The place where the film 4 is travelling is detected by detecting these elements by the film sensor 58. The loading operation is stopped when the first element is detected, under which condition the end of the leader film portion of the film 4 is wound on the take-up spool 10, and at least the starting end of the sensitive surface of the film 4 reaches the position at which it comes in contact with the light emitting surface 17a of the FOT 17.

A torque limiter 59 is interposed between the spool shaft 49 of the take-up spool 10 and a drive member to be described later, as shown in Figure 2. The take-up spool 10 has a torque thereon to take up the film 4 at a speed faster than the film travel speed given by the press rollers 11 and 12. After the film 4 has been wound around the take-up spool 10, the torque limiter 59 slips relative to the drive member, so that the film 4 can be wound with no slack.

Referring to Figures 1 and 2, there is provided a roller shaft 60 which is rotatably supported by the back side partitioning plate 43′. A portion of the roller shaft 60 projects to the front side from the plate 43′ and is secured to the rewind roller 22. When the cassette 2 is placed in the cassette receiving section 9, the rewind roller 22 is brought into contact with the outer peripheral surface of the flange 5′ of the supply spool 6.

The rewind roller 22 is driven by the drive means which will be described later, only in the film rewinding mode, to rotate in the clockwise direction in Figure 1, causing the supply spool 6 to rotate in the film rewinding direction, or in the counter-clockwise direction in Figure 1. In other modes, the rewind roller 22 is rotated in the counter-clockwise direction by the rotating supply spool 6.

The FOT 17 emits light rays, for example, ultraviolet rays of three different wavelengths for hardening the corresponding three different photosensitive microcapsules on the sensitive surface. The three different wavelengths are respectively emitted from three light emitting lines 61, 62 and 63 vertically arranged in the light emitting surface 17a (see Figure 3), and they correspond to the three different primary colour patterns of the picture elements of one line of a predetermined colour picture.

When the exposure operation is started, the stepping motor 38 is rotated in synchronism with the light emission timing from the FOT 17, and thus causes the film feed rollers 14 and 15 to rotate so that the film 4 is moved by an amount of a constant pitch at a time in the forward direction. The sensitive surface (the film 4 is loaded so that the photosensitive surface thereof faces the FOT 17) is exposed at every light line at the position facing the light emitting lines 61, 62 and 63 over the entire area or a predetermined area of the sensitive surface.

As the film 4 is exposed step by step, it becomes slack between the film rollers 14 and 15 and the press rollers 11 and 12. When the slack of the film 4 increases to a certain amount, it is detected by a slack sensor which will be described later, with the result that the press rollers 11 and 12 rotate to remove the slack of the film 4.

The film 4, when exposed to light, produces a film frame corresponding to a predetermined picture. When one frame has been produced, the leader of the film frame reaches the position near the entry side of the press rollers 11 and 12. Substantially at the same time or immediately thereafter, one of the elements on the film 4 is detected by the film sensor 58, so that the stepping motor 38 stops rotating.

Referring to Figures 1 and 2, a tension roller 64 is provided above the film guide plate 13 and slightly to the right of the mid point between the left and right ends of the film guide plate 13.

Roller support arms 65 and 65′ are rotatably supported by the support chassis 36 and 36′. The tension roller 64 is rotatably supported between the left pivotal ends of the roller support arms 65 and 65′, which are resiliently urged to rotate in the counter-clockwise direction in Figure 1 by resilient means (not shown). Therefore, the tension roller 64 is moved substantially downward so as continuously resiliently to press the film 4 downward.

A slack sensor 66 is provided, and has a so-called photo-interrupter structure. The slack sensor 66 is supported by the rear side one of the chassis 36 and 36′, and has a light emitting element 66a and a light receiving element 66b which oppose through the right pivotal end of the roller support arm 65′.

The slack sensor 66 generates a signal for causing the press roller 11 to rotate when the right end of the roller support arm 65′ interposed between the light emitting element 66a and the light receiving element 66b is moved to block the path of the light from the light emitting element 66a to the light receiving element 66b.

When loading of the film 4 has been completed, the film 4 is tensioned between the film feed rollers 14 and 15 and the press rollers 11 and 12 as indicated by the solid line in Figure 1, and thus the tension roller 64 is pushed upward by the film 4 to rest thereon in the position indicated by the solid line in Figure 1. In this condition, the right end portion of the roller support arm 65′ is out of the light path in the slack sensor 66.

As the exposing operation advances, the film 4 is moved forward by the film feed rollers 14 and 15, and thus the film 4 becomes increasingly slack between the film feed rollers 14 and 15 and the press rollers 11 and 12. With increase in the slack, the tension roller 64 and the roller support arms 65 and 65′ are moved in the counter-clockwise direction by the pivotal force exerted upon the roller support arms 65 and 65′. When the slack in the film 4 is such that the film 4 comes close to the film guide plate 13, the right end portion of the roller support arm 65′ blocks the path of the light between the light emitting element 66a and the light receiving element 66b of the slack sensor 66 as indicated by the two-dot chain line in Figure 1, so the slack sensor 66 generates the signal for the rotation of the press roller 11.

Then, the press roller 11 is rotated in the counter-clockwise direction to move the slack part of the film 4 that lies ahead of the film feeding rollers 14 and 15, so removing the slack. When the slack has been removed, the tension roller 64 is moved upward to cause the right end portion of the roller support arm 65′ to come out of the slack sensor 66, so the press roller 11 is stopped from rotating.

During the exposure of the film 4, the operation for removing the slack is repeated.

Figures 1 to 3 show a shaft 67 of the paper supply roller 19. The shaft 67 is rotatably supported at its ends between the arms 23b and 23′b of the downward side roller supports 23 and 23′. When each sheet of printing paper 7 is fed (hereinafter, referred to as the "paper supply mode"), the roller 19 is rotated in the clockwise direction in Figure 1.

The paper supply tray 18 is inserted into the outer case 8 through a tray insertion opening 68 that is formed at the lower portion of the right-hand side wall 8e of the outer case 8. When the tray 18 is inserted to a predetermined tray set position, the left end of the tray 18 comes just below the paper supply roller 19 and the left end portion of a pushing-up plate 69 is sprung up by resilient means not shown, pushing the stacked sheets of printing paper 7 upward, so that the leading end of the top one of the stacked printing papers 7 placed on the pushing-up plate 69 is pressed against the paper supply roller 19.

Paper guides 70 and 70′ are disposed to oppose to each other in such a manner that the distance therebetween becomes narrower towards their left ends, their right ends close to the leading end of the upper surface of the paper supply tray 18, and their left ends close to the entry side of the contact portion of the press rollers 11 and 12 from the right down side.

When exposure to one image has been completed, the film sensor 58 generates a predetermined signal, causing the paper supply roller 19 to be rotated in the clockwise direction so that the top one of the printing papers 7 is fed by the paper supply roller 19 and guided by the paper guides 70 and 70′ so that its leading end is inserted between the film 4 and the downward side press roller 11.

Then, when the press roller 11 is rotated in the counter-clockwise direction, the thus fed printing paper 7 is overlapped with the exposed frame of the film 4 and transported together therewith, passing between the press rollers 11 and 12 so that the picture is printed on the printing paper 7.

A first paper discharge guide plate 71 is disposed between the exit side of the contact portion of the press rollers 11 and 12, and the paper discharge belt 20 and close to the under side of the separate flap 57. The separate flap 57 is in the separate position except when the film 4 is being loaded, and therefore the separate flap 57 and the first paper discharge guide plate 71 are combined to form a space for guiding the printing paper 7 that emerges from between the press rollers 11 and 12.

There is provided a second paper discharge guide plate 72 disposed in such a position that its right end is spaced by a slight distance from the left end portion of the first paper discharge guide plate 71, and its left end lies above the root portion of the paper discharge tray 21, with its right end portion sloping slightly down to the right.

Referring to Figures 1 to 3, there are provided paper discharge rollers 73 and 73′, and 74 and 74′. The right-hand side paper discharge rollers 73, 73′ are arranged one over the other with their line of contact close to the left end of the first paper discharge guide plate 71. The left-hand side paper discharge rollers 74, 74′ are also arranged one over the other with their line of contact close to the left end of the second paper discharge guide plate 72.

The downward side rollers 73 and 74 have shafts 75 and 76 rotatably supported between the support chassis 33 and 33′, and the upward side rollers 73′ and 74′ have shafts 75′ and 76′ rotatably supported between the pivotal end portions of the roller support arms 77, 77 and 78, 78 (only one side is shown) that are rotatably supported by the support chassis 33 and 33′. Moreover, the upward side paper discharge rollers 73′ and 74′ are resiliently forced to rotate by the roller support arms 77, 77 and 78, 78, and thereby to be pressed against the downward side paper discharge rollers 73 and 74.

The endless paper discharge belt 20 extends between the upward side paper discharge rollers 73′ and 74′. Therefore, the left and right ends of the lower side part of the paper discharge belt 20 are brought into contact with the downward side paper discharge rollers 73 and 74, and most of the lower surface thereof is in light contact with the upper surface of the second paper discharge guide plate 72.

The downward side left-hand paper discharge roller 74 is rotated in the counter-clockwise direction in Figure 1 by a drive member which will be described later. When this paper discharge roller 74 is rotated in the counter-clockwise direction, the lower part of the paper discharge belt 20, facing the second paper discharge guide plate 72 is moved from the right to the left, and the downward side right-hand paper discharge roller 73 is rotated in the counter-clockwise direction.

Referring to Figure 1, there is provided a printing completion sensor 79 for detecting the trailing end of the printing paper 7 emerging from between the press rollers 11 and 12, and disposed under the first paper discharge guide plate 71 at a position close to a hole 71 therein.

When the printing operation has started, the paper discharge roller 74 is rotated in the counter-clockwise direction, and the printing paper 7 and the film 4 come forward from between the press rollers 11 and 12 while being pressed therebetween. The leading edge of the overlap of the film 4 and the printing paper 7 by the sharp edge of the right end of the separate flap 57. The thus separated printing paper 7 is guided to pass between the separate flap 57 and the first paper discharge guide plate 71 and is then pulled through the entry side of the line of contact between the paper discharge belt 20 and the second paper discharge guide plate 72 into the space between the paper discharge belt 20 and the second paper discharge guide plate 72. This printing paper 7 is further carried by the paper discharge belt 20 and pulled through the exit side of the line of contact between the paper discharge belt 20 and the paper discharge roller 74 into the paper discharge tray 21.

When the trailing end of the printing paper 7 passes over the printing completion sensor 79, the printing completion sensor 79 generates a predetermined signal to start rewinding of the film 4.

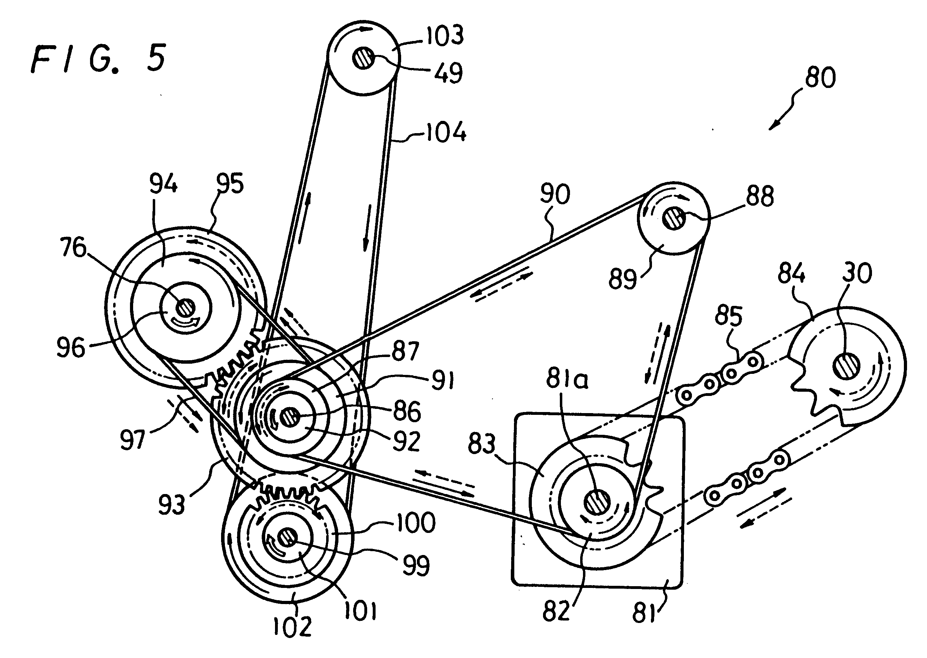

Referring to Figures 1, 2, 4 and 5, there is provided a drive means 80 which drives the print and paper discharge system. In other words, the drive means 80 is used to drive the press roller 11, the take-up spool 10, the travel assisting roller 32 and the paper discharge roller 74 to rotate. The drive means 80 causes the film 4 to travel and be wound on the take-up spool 10, the printing paper 7 to be subjected to the printing and the printing paper 7 to be discharged. The solid arrows in Figure 5 indicate the transport direction or rotation direction upon printing, and the broken arrows indicate the same upon rewinding of the film 4.

There is provided a motor 81 with a decelerator, and hereinafter referred to as "printing motor". The printing motor 81 is fixed to the right front end portion of the support chassis 33′. The rotating shaft 81a of the printing motor 81 projects backward from the support chassis 33′ and has on its front end portion a securely mounted sprocket wheel 82 and similarly on its back end portion a chain gear 83.

The shaft 81a of the printing motor 81 rotates in the counter-clockwise direction in Figure 1 upon printing, but in the clockwise direction upon rewinding of the film 4.

A chain gear 84 is fixed to the back portion of the shaft 30 of the downward side press roller 11 which projects backward from the roller support 23′. An endless chain 85 extends between the gear 84 and the gear 83 fixed to the shaft 81 of the printing motor 81. When the printing motor 81 is driven to rotate, the press roller 11 rotates in the same direction. Therefore, the press roller 11 is rotated in the counter-clockwise direction in the printing mode, but in the clockwise direction in the film rewinding mode.

A first transmission shaft 86 is rotatably supported between the support chassis 33 and 33′. A relatively small-diameter sprocket wheel 87 is secured to the front end of the portion of the shaft 86 projecting backward from the support chassis 33′. The downward side travel assisting roller 32 has a shaft 88 to which sprocket wheel 88 is fixed at the portion projecting backward from the support chassis 33′.

An endless timing belt 90 extends around the sprocket wheel 89, the sprocket wheel 87 fixed to the first transmission shaft 86 and the sprocket wheel 82 fixed to the shaft 81a of the printing motor 81.

Therefore, in the printing mode, the printing motor 81 is rotated counter-clockwise, causing the timing belt 90 to travel in the solid arrow direction in Figure 5. Consequently, the first transmission shaft 86 and the travel assisting roller 32 are rotated in the counter-clockwise direction. In the film rewinding mode, the printing motor 81 is rotated in the clockwise direction, causing the timing belt 90 to travel in the broken arrow direction in Figure 5. Thus, the first transmission shaft 86 and the travel assisting roller 32 are rotated in the clockwise direction.

There is provided a sprocket wheel 91 which is located at the back of the sprocket wheel 87 and which is coupled through a one-way clutch 92 to the first transmission shaft 86. A first transmission gear 93 is located at the back of the sprocket wheel 91 and secured to the first transmission gear 86. The one-way clutch 92 is constructed to couple the first transmission shaft 86 to the sprocket wheel 91 only when the first transmission shaft 86 is rotated counter-clockwise relative to the sprocket wheel 91.

A sprocket wheel 94 is secured to the portion of the shaft 76 of the paper discharge roller 74 projecting backward from the support chassis 33′. A second transmission gear 95 is located at the back of the sprocket wheel 94 and coupled through a one-way clutch 96 to the shaft 76. An endless timing belt 97 is extended between the sprocket wheel 94 and the sprocket wheel 91 fixed to the first transmission shaft 86, and the second transmission gear 95 is meshed with the first transmission gear 93.

The one-way clutch 96 is constructed to couple the shaft 76 to the second transmission gear 95 only when the second transmission gear 95 is rotated counter-clockwise relative to the shaft 76 of the paper discharge roller 74 in Figure 5.

Thus, as described above, since in the printing mode the first transmission shaft 86 is rotated in the counter-clockwise direction, the first transmission shaft 86 and the sprocket wheel 91 are coupled through the one-way clutch 92, and consequently the timing belt 97 is moved in the solid arrow direction in Figure 5, so that the paper discharge roller 74 is rotated in the counter-clockwise direction in Figure 1.

At this time, the first transmission gear 93 is rotated in the counter-clockwise direction, causing the second transmission gear 95 to rotate in the clockwise direction. When the second transmission gear 95 is rotated in this direction, the one-way clutch 96 is not interlocked therewith, so that upon printing, the second transmission gear 95 does not interfere with the shaft 76 of the paper discharge roller 74.

Also, as described above, since the first transmission shaft 86 is rotated in the clockwise direction in the film rewinding mode, the first transmission gear 93 is rotated in the clockwise direction, causing the second transmission gear 95 to rotate in the counter-clockwise direction. In this condition, the second transmission gear 95 and the shaft 76 of the paper discharge roller 74 are connected through the one-way clutch 96, and thus the paper discharge roller 74 is rotated in the counter-clockwise direction.

At this time, the sprocket wheel 94 is fixed to the shaft 76 of the paper discharge roller 74 is also rotated in the counter-clockwise direction, causing the larger sprocket wheel 91 provided on the first transmission shaft 86 to be rotated in the counter-clockwise direction as a result of transmitting this rotation through the timing belt 97 to the sprocket wheel 91. Since the sprocket wheel 91 is coupled to the first transmission shaft 86 only when rotated in the clockwise direction relative to the transmission shaft 86, the sprocket wheel 91 and the first transmission shaft 86 do not interfere with each other in the film rewinding mode.

The paper discharge roller 74 is rotated counter-clockwise in either the printing mode or the film rewinding mode, and thus the printing paper 7 fed out from between the press rollers 11 and 12 is sure to be fed to the paper discharge tray 21 even if the film rewinding operation begins immediately after the end of the printing operation.

The driving system of the take-up spool 10 will be described next.

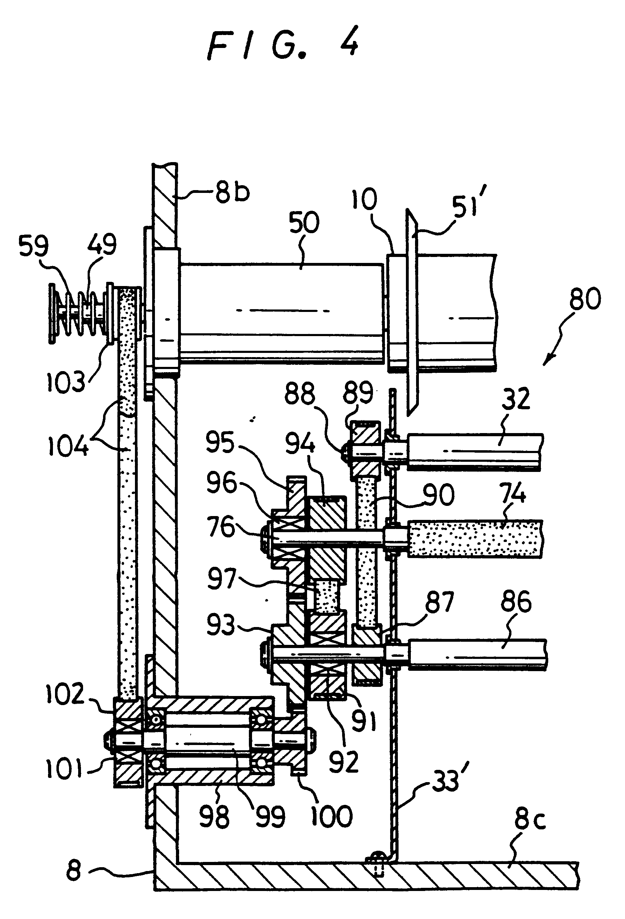

Referring particularly to Figures 4 and 5, a bearing housing 98 is supported by the back wall 8b of the outer case 8 at its lower end portion. A second transmission shaft 99 is rotatably supported in the bearing housing 98. To the front side portion of the second transmission shaft 99 is secured a third gear 100 that is meshed with the first transmission gear 93. To the back end portion of the second transmission shaft 99 is coupled through a one-way clutch 101 a sprocket wheel 102. The one-way clutch 101 is constructed to couple the second transmission shaft 99 to the sprocket wheel 102 only when the second transmission shaft 99 is rotated clockwise relative to the sprocket wheel 102.

A sprocket wheel 103 is fixed to the portion of the spool shaft 49 of the take-up spool 10 that projects backward from the outer case 8. An endless timing belt 104 extends between the sprocket wheel 103 and the sprocket wheel 102 on the second transmission shaft 99.

Thus, as described above, since the first transmission gear 93 is rotated counter-clockwise in the printing mode, the third transmission gear 100 engaged therewith and the second transmission shaft 99 are rotated clockwise in Figure 5. When the second transmission gear 99 is rotated in this direction, the sprocket wheel 102 is also rotated clockwise through the one-way clutch 101.

Thus, since the timing belt 104 travels in the direction of the arrow in Figure 5, the take-up spool 10 is rotated in the clockwise direction in Figure 1, or in the film rewinding direction.

In the film rewinding mode, the first transmission gear 93 is rotated in the clockwise direction, causing the third transmission gear 100 and the second transmission shaft 99 to be rotated in the counter-clockwise direction. When the second transmission shaft 99 is rotated in this direction, the one-way clutch 101 does not couple the second transmission shaft 99 to the sprocket wheel 102, so that the sprocket wheel 102 is not driven to rotate by the second transmission shaft 99.

As the film 4 is withdrawn from the take-up spool 10, the take-up spool 10, the spool shaft 49 and the sprocket wheel 103 are rotated together in the counter-clockwise direction, and thus this rotation is transmitted through the timing belt 104 to the sprocket wheel 102 of the second transmission shaft 99, so that the sprocket wheel 102 is rotated in the counter-clockwise direction.

Referring to Figures 1, 2, 6 and 7, there is provided a drive section 105 which drives the paper supply and film rewinding system. In other words, the drive section 105 drives the paper supply roller 19 and the rewind roller 22 to rotate. The drive section 105 serves to supply the printing paper 7, and rewind the film 4 on the supply spool 6.

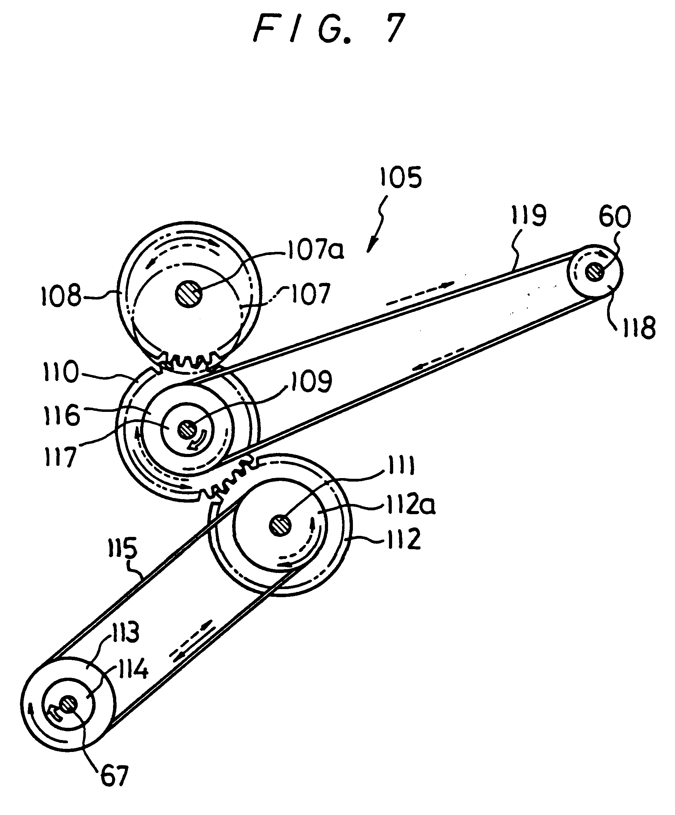

In Figure 7, the solid arrows show the rotational direction and the travelling direction upon supply of paper, and the broke arrows indicate them upon rewinding of the film 4.

There is provided a gear supporting chassis 106 of substantially U-shape as viewed from above, secured to the back of the support chassis 36′ as shown in Figure 2.

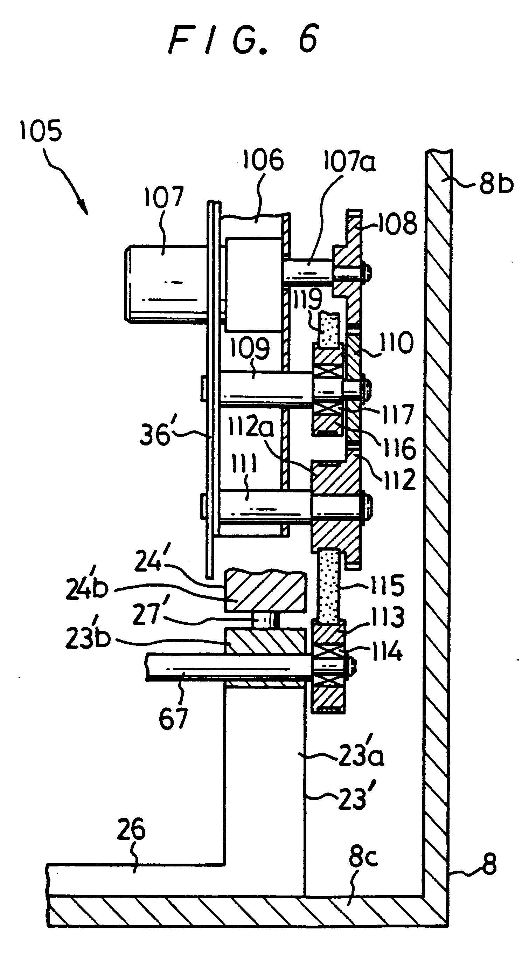

Referring to Figure 6, a motor 107 (hereinafter, referred to as the "paper supply motor") is provided to drive the paper supply roller 19 and the rewind roller 22 to rotate. The paper supply motor 107 is fixed to the gear support chassis 106, and a gear 108 is fixed to the portion of its shaft 107a that projects backward from the gear support chassis 106.

The paper supply motor 107 is rotated in the clockwise direction in Figures 1 and 7 in the paper supply mode, and in the counter-clockwise direction in the film rewinding mode.

A transmission shaft 109 is rotatably supported by the gear support chassis 106. A first transmission gear 110 is fixed to the end of the portion of the transmission shaft 109 that projects backward from the support chassis 106. A gear support shaft 111 is fixed to the gear support chassis 106. A second transmission gear 112 meshed with the first transmission gear 110 is rotatably supported by the portion of the gear support shaft 111 that projects backward from the gear support chassis 106. A sprocket wheel 112a is provided integral with the second transmission gear 112.

A sprocket wheel 113 is coupled through a one-way clutch 114 to the rear end of the shaft 67 of the paper supply roller 19. An endless timing belt 115 extends between the sprocket wheel 113 and the sprocket wheel 112a of the second transmission gear 112.

The one-way clutch 114 couples the shaft 67 to the sprocket wheel 113 only when the sprocket wheel 113 is rotated clockwise relative to the shaft 67 of the paper supply roller 19.

Thus, as described above, since the paper supply motor 107 is rotated clockwise in the paper supply mode, the transmission shaft 109 and the transmission gear 110 are rotated counter-clockwise, and the second transmission gear 112 and its sprocket wheel 112a are rotated clockwise, with the result that the timing belt 115 is moved in the solid arrow direction in Figure 7.

Thus, since the sprocket wheel 113 is rotated in the clockwise direction, it is coupled through the one-way clutch 114 to the shaft 67 of the paper supply roller 19, causing the paper supply roller 19 to rotate clockwise.

Since the paper supply motor 107 is rotated counter-clockwise in the film rewinding mode, the first transmission gear 110 is rotated clockwise, and the second transmission gear 112 and its sprocket wheel 112a are rotated counter-clockwise, so that the timing belt 115 is moved in the broken arrow direction in Figure 7, causing the sprocket wheel 113 to rotated counter-clockwise. When the sprocket wheel 113 is rotated in this direction, the one-way clutch 114 runs idle with no rotation transmitted to the shaft 67 of the paper supply roller 19.

As Figure 6 shows, there is provided a sprocket wheel 116 which is located at the front of the first transmission gear 110 and is coupled through a one-way clutch 117 to the transmission shaft 109. A sprocket wheel 118 is fixed to the rear end of the shaft 60 of the rewind roller 22 as shown in Figure 2. An endless timing belt 119 extends between the sprocket wheel 118 and the sprocket wheel 116.

The one-way clutch 117 couples the transmission shaft 109 to the sprocket wheel 116 only when the transmission shaft 109 is rotated in the clockwise direction in Figure 7 relative to the sprocket wheel 116.

Thus, in the paper supply mode, since the transmission shaft 109 is rotated counter-clockwise, the one-way clutch 117 runs idle with no rotation of the transmission shaft 109 transmitted to the sprocket wheel 116. Thus, the rewinding roller 22 is not rotated by the paper supply motor 107.

As the film 4 is withdrawn from the supply spool 6 of the cassette 2, the supply spool 6 is rotated clockwise, causing the rewind roller 22 to rotate counter-clockwise. This rotation is transmitted through the timing belt 119 to the sprocket wheel 116, so that the sprocket wheel 116 is rotated counter-clockwise. Since the sprocket wheel 118 of the rewind roller 22 is much smaller in diameter than the sprocket wheel 116, the rotation of the rewind roller 22 is decelerated and transmitted to the sprocket wheel 116. As a result, even if the sprocket wheel 116 is rotated counter-clockwise by the rewind roller 22, this rotation is in the clockwise direction relative to the transmission shaft 109, which is rotating counter-clockwise at high speed so that the one-way clutch 117 still runs idle.

In the film rewinding mode, since the transmission shaft 109 is rotated clockwise as mentioned above, the transmission shaft 109 is coupled through the one-way clutch 117 to the sprocket wheel 116. Thus, the sprocket wheel 116 is rotated clockwise, driving the timing belt 119 to move in the broken arrow direction in Figure 7 with the result that the rewind roller 22 is rotated clockwise. Therefore, the supply spool 6 is rotated counter-clockwise, that is, in the direction to take up the film 4.

The printer 1 thus operates to expose the film 4 to light, supply the printing paper 7, print an image on the printing paper 7, discharge the printed paper, and rewind the film 4.

When a printing operation start command is issued with the film 4 loaded as described above, the film 4 is fed forward by a constant amount at a time by the film feed rollers 14 and 15, and the sensitive surface of the film 4 is exposed to light line by line by the FOT 17 to form a photographic film frame of one picture.

Substantially just when or immediately after the exposure has been completed, the film sensor 58 detects that the leading end of the frame of the film 4 has arrived at the position near the entry side of the contact between the press rollers 11 and 12. Then, the paper supply motor 107 is rotated clockwise, causing the paper supply roller 19 to rotate clockwise, and thus to feed on by one the printing papers 7 between the press rollers 11 and 12.

When the printing paper 7 has been completely supplied, the paper supply motor 107 stops rotating and the printing motor 81 is rotated counter-clockwise, causing the press roller 11 to rotate counter-clockwise, the travel assisting roller 32 to rotate counter-clockwise, the paper discharge roller 74 to rotate counter-clockwise, and the take-up spool 10 to rotate clockwise.

Accordingly, the film 4 is moved forward and the printing paper 7 and the film 4 are fed together and pressed between the press rollers 11 and 12 with the printing paper 7 overlapped with the exposed sensitive surface of the frame of the film 4, and in contact therewith face to face. During this process, of all the photosensitive microcapsules on the sensitive surface of the frame of the film 4, the capsules which were not exposed to light from the FOT 17 are broken by the pressure to release their colouring precursor substance, which is transferred to the printing paper 7 so that the predetermined picture is printed on the printing paper 7.

When the developed printing paper 7 has completely come out from between the press rollers 11 and 12 and its trailing end has passed over the printing completion sensor 79, the printing completion sensor 79 generates the predetermined signal.

At this time, the leading end of the non-exposed portion of the film 4 comes to the contact portion between the press rollers 11 and 12, or somewhat before that portion.

When the printing completion sensor 79 generates a signal, the printing motor 81 is rotated in the reverse or clockwise direction, and the paper supply motor 107 is rotated counter-clockwise.

Thus, the press roller 11 is rotated clockwise and the travel assisting roller 32 rotated clockwise, that is both the rollers are rotated in the reverse direction, while the paper discharge roller 74 is still rotated in the same or counter-clockwise direction, and the rewind roller 22 is rotated clockwise.

The film 4 is therefore moved in the reverse direction, that is, drawn off the take-up spool 10 and transported to the supply spool 6, while the supply spool 6 is rotated in the film winding direction to return part of the film 4 which has been taken out of the case 3. The take-up spool 10 is rotated counter-clockwise by the film 4 being drawn off it, the torque limiter 59 providing an appropriate back tension.

When the rewind roller 22 has been rotated a predetermined number of times, a signal is generated from the revolution counter/sensor (not shown), which is associated with the shaft 60 of the rewind roller 22, thus causing the paper supply motor 107 and the printing motor 81 to stop rotating.

The film 4 previously withdrawn from the case 3 is rewound on the supply spool 6 by a predetermined amount, or until the leading end of the non-exposed portion of the film 4 is fed back to the position opposite to the light emitting surface 17a of the FOT 17. Thus, the exposure of the film 4 to the next light image is made from the position near the rear end of the previously exposed frame.

While the film 4 is being rewound in this way, the printing paper 7 is being fed to the paper discharge tray 21 by the paper discharge belt 20.

Thus, with the embodiment, since the sensitive surface of the film is always exposed from just beyond the previously exposed portion, the film can be effectively used with no waste.

In this embodiment, since the driving system of the printing paper supply means is operated in association with the rotating members of the film winding means and it is constructed also to serve as the driving system of the film winding means, by providing one-way clutches at appropriate positions, there is no need to provide a special driving system in the film rewinding means, resulting in a simple construction of the printer.

Alternatively, however, a special driving system may be provided exclusively for the film rewinding means.

While in this embodiment the printing operation on the printing paper is started each time the exposure of the photosensitive film to light has been completely made for one full picture, the printing operation may be started when a frame of the photosensitive film has been partly exposed to light and the remaining part of the picture is still being exposed. The photosensitive film is then rewound after the printing operation has been completed for the full picture.

Moreover, while in the embodiment the photosensitive microcapsules in the exposed photosensitive film are broken by pressure, and the microcapsules correspond to a plurality of different colours and are sensitive to different, corresponding light rays, the film used need not have such photosensitive characteristics, and the colouring precursor substances need not be so-called all colour, but alternatively may have any suitable photosensitive characteristics as long as the precursor substances, when exposed, act on the printing paper, with or without colour.

This invention can also be applied to an all-colour printer capable of printing pictures in all colour by effecting the printing operation a plurality of times through a plurality of photosensitive films which have respectively provided thereon a plurality of different kinds of colouring precursor substance for different colours, thereby producing an all-colour picture.

## Claims

1. A printer (1) for printing an image on a sheet of printing paper (7) by exposing a sensitive surface of an elongated photosensitive film (4) carrying photosensitive microcapsules to light corresponding to said image to form a photographic film frame, overlapping the exposed surface of the film (4) on the printing paper (7), and applying pressure to the overlapping portion, the printer (1) comprising:
a supply spool (6) on which the film (4) is wound;
a take-up spool (10) on which the film (4) withdrawn from said supply spool (6) is wound;
exposing means (17) for exposing the portion of the film (4) facing said exposing means (17) to light;
printing paper supplying means (18, 70, 70') for supplying the printing paper (7); and
feeding means (14, 15, 32, 32', 103, 104) for feeding the film (4) in the winding direction from the supply spool (6) towards the take-up spool (10), so that the exposed portion is moved from the position facing the exposing means (17) towards a position where press rollers (11, 12) are located;
said press rollers (11, 12) causing the film (4) to overlap with the supplied printing paper (7) and pressing the overlapping portion while the film (4) and the printing paper (7) are being passed together between said rollers (11, 12) in the winding direction;
characterized by:
film rewinding means (107) for permitting said supply spool (6) to rotate in the film rewinding direction opposite to said winding direction; and
roller drive means (81) for driving the press rollers (11, 12) to rotate;
said film rewinding means (107) being constructed such that, after the printing of the printing paper (7), said film rewinding means (107) is driven to rewind the film (4) until the part of the non-exposed portion of the film (4) adjacent to the exposed portion of the film (4) is returned to the position facing said exposing means (17).

2. A printer (1) according to claim 1 wherein said film rewinding means (107) comprises a first electric motor (107).

3. A printer (1) according to claim 2 wherein said printing paper supplying means (18, 70, 70') also comprises said first electric motor (107).

4. A printer (1) according to claim 1, claim 2 or claim 3 wherein said exposing means (17) comprises a fibre optical tube (17).

5. A printer (1) according to any one of the preceding claims wherein said roller drive means (81) comprises a second electric motor (81).

## Patentansprüche

1. Drucker (1) zum Ausdrucken eines Bildes auf einem Blatt Druckpapier (7) durch Belichten einer empfindlichen Oberfläche eines länglichen lichtempfindlichen Films (4), der lichtempfindliche Mikrokapseln trägt, mit Licht, das dem Bild entspricht, um ein einzelnes photographisches Filmbild zu bilden, Legen der belichteten Oberfläche des Films (4) über das Druckpapier (7) und Ausüben eines Drucks auf den überlagernden Abschnitt, wobei der Drucker umfaßt:
eine Zuführungsrolle (6), auf die der Film (4) gewickelt ist,
eine Aufnahmerolle (10), auf die der Film (4), der von der Zuführungsrolle (6) abgezogen ist, gewickelt wird,
ein Belichtungsmittel (17) zum Belichten des Abschnitts des Films (4), der dem Belichtungsmittel (17) gegenüberliegt, mit Licht,
ein Druckpapier-Zuführungsmittel (18, 70, 70') zum Zuführen des Druckpapiers (7) und
Vorschubmittel (14, 15, 32, 32', 103, 104) zum Vorbewegen des Films (4) in der Wickelrichtung von der Zuführungsrolle (6) zu der Aufnahmerolle (10), so daß der belichtete Abschnitt von der Position, die dem Belichtungsmittel (17) gegenüberliegt, in Richtung auf eine Position bewegt wird, wo Druckrollen (11, 12) angeordnet sind,
wobei die Druckrollen (11, 12) veranlassen, daß sich der Film (4) mit dem zugeführten Druckpapier (7) überlagert, und den überlagernden Abschnitt andrücken, während der Film (4) und das Druckpapier (7) zusammen zwischen den Rollen (11, 12) in der Wickelrichtung durchlaufen,
**gekennzeichnet** durch
ein Filmrückspulmittel (107), das der Zuführungsrolle (6) erlaubt, sich in der Filmrückspulrichtung entgegengesetzt zu der Wickelrichtung zu drehen, und
ein Rollenantriebsmittel (81) zum Antreiben der Druckrollen (11, 12), um diese zu drehen,
wobei das Filmrückspulmittel (107) derart aufgebaut ist, daß das Filmrückspulmittel (107) nach dem Bedrucken des Druckpapiers (7) angetrieben wird, um den Film (4) zurückzuspulen, bis der Teil des nichtbelichteten Abschnitts des Films (4), der an den belichteten Abschnitt des Films (4) grenzt, zu der Position zurückgekehrt ist, die dem Belichtungsmittel (17) gegenüberliegt.

2. Drucker (1) nach Anspruch 1, bei dem das Filmrückspulmittel (107) einen ersten Elektromotor (107) umfaßt.

3. Drucker (1) nach Anspruch 2, bei dem das Druckpapier-Zuführungsmittel (18, 70, 70') auch den ersten Elektromotor (107) umfaßt.

4. Drucker (1) nach Anspruch 1, 2 oder 3, bei dem das Belichtungsmittel (17) ein Faseroptikrohr (17) umfaßt.

5. Drucker (1) nach einem der vorhergehenden Ansprüche, bei dem das Rollenantriebsmittel (81) einen zweiten Elektromotor (81) umfaßt.

## Revendications

1. Imprimante (1) destinée à imprimer une image sur une feuille de papier d'impression (7) par exposition d'une surface sensible d'un film photosensible allongé (4) qui porte des microcapsules photosensibles à la lumière correspondant à l'image pour la formation d'un cadre sur le film photographique, par mise en recouvrement de la surface exposée du film (4) et de la feuille de papier d'impression (7), et par application d'une pression à la partie de recouvrement, l'imprimante (1) comprenant
une bobine débitrice (6) sur laquelle est enroulé le film (4),
une bobine réceptrice (10) sur laquelle s'enroule le film (4) qui a été retiré de la bobine débitrice (6),
un dispositif (17) d'exposition de la partie du film (4) tournée vers le dispositif (17) d'exposition à la lumière,
un dispositif (18, 70, 70') d'alimentation en feuilles de papier d'impression (7), et
un dispositif (14, 15, 32, 32', 103, 104) destiné à faire avancer le film (4) dans le sens d'enroulement, de la bobine débitrice (6) vers la bobine réceptrice (10), afin que la partie exposée se déplace d'une position qui se trouve en face du dispositif d'exposition (17) vers une position à laquelle se trouvent des rouleaux de pression (11, 12),
les rouleaux de pression (11, 12) provoquant le recouvrement du film (4) et de la feuille de papier d'impression (7) qui a été transmise et la compression de la partie de recouvrement lorsque le film (4) et la feuille de papier d'impression (7) passent ensemble entre les rouleaux (11, 12) dans le sens d'enroulement,
caractérisée par
un dispositif (107) de réenroulement de film destiné à permettre à la bobine débitrice (6) de tourner dans le sens de réenroulement de film qui est opposé au sens d'enroulement, et
un dispositif (81) d'entraînement des rouleaux de pression (11, 12) afin que ceux-ci tournent,
le dispositif (107) de réenroulement de film ayant une construction telle que, après l'impression de la feuille de papier d'impression (7), le dispositif (107) de réenroulement de film est entraîné afin qu'il réenroule le film (4) jusqu'à ce que la portion de la partie non exposée du film (4) qui est adjacente à la partie exposée du film (4) revienne en face du dispositif d'exposition (17).

2. Imprimante (1) selon la revendication 1, dans laquelle le dispositif (107) de réenroulement de film comprend un premier moteur électrique (107).

3. Imprimante (1) selon la revendication 2, dans laquelle le dispositif (18, 70, 70') d'alimentation en feuilles de papier d'impression comporte aussi le premier moteur électrique (107).

4. Imprimante (1) selon la revendication 1, 2 ou 3, dans laquelle le dispositif d'exposition (17) comporte un tube (17) de fibres optiques.

5. Imprimante (1) selon l'une quelconque des revendications précédentes, dans laquelle le dispositif (81) d'entraînement des rouleaux comprend un second moteur électrique (81).
